(19) Europäisches Patentamt
European Patent Office
Office européen des brevets

(11) EP 4 498 105 A1

(12) **EUROPEAN PATENT APPLICATION**
published in accordance with Art. 153(4) EPC

(43) Date of publication:
29.01.2025 Bulletin 2025/05

(51) International Patent Classification (IPC):
G01R 33/12 (2006.01)     G01N 27/72 (2006.01)
H01F 41/00 (2006.01)

(21) Application number: 23815773.9

(22) Date of filing: 16.05.2023

(52) Cooperative Patent Classification (CPC):
G01N 27/72; G01R 33/12; H01F 41/00

(86) International application number:
PCT/JP2023/018326

(87) International publication number:
WO 2023/234013 (07.12.2023 Gazette 2023/49)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 30.05.2022 JP 2022087939

(71) Applicant: JFE Steel Corporation
Tokyo 100-0011 (JP)

(72) Inventors:
• INOUE, Hirotaka
  Tokyo 100-0011 (JP)
• OMURA, Takeshi
  Tokyo 100-0011 (JP)

(74) Representative: Hoffmann Eitle
Patent- und Rechtsanwälte PartmbB
Arabellastraße 30
81925 München (DE)

(54) **DATA SET GENERATION METHOD, ELECTROMAGNETIC FIELD ANALYSIS METHOD AND COMPUTER PROGRAM**

(57) A data set generation method is a method of acquiring two-dimensional magnetic properties and includes measuring a first magnetic field strength vector generated in an analysis target in response to first elliptical magnetization applied clockwise, measuring a second magnetic field strength vector generated in the analysis target in response to second elliptical magnetization applied counterclockwise, calculating a first average magnetic field strength vector by averaging the first magnetic field strength vector and the second magnetic field strength vector, calculating a first average magnetic flux density vector by averaging a first magnetic flux density vector corresponding to the first elliptical magnetization and a second magnetic flux density vector corresponding to the second elliptical magnetization, and generating a data set of the two-dimensional magnetic properties that associates the first average magnetic field strength vector and the first average magnetic flux density vector.

FIG. 1

**Description**

TECHNICAL FIELD

The present disclosure relates to a method of generating a data set, a method of analyzing an electromagnetic field, and a computer program used to analyze the magnetic properties of magnetic bodies, such as the iron core of electrical equipment, mainly the iron core of a transformer, by capturing magnetic field strength and magnetic flux density as vector quantities.

BACKGROUND

Grain-oriented electrical steel sheets with a crystalline microstructure in which the <001> orientation, which is the easy magnetization axis of iron, is highly aligned in the rolling direction of the steel sheet are used as iron core materials, especially for power transformers. There are various requirements for transformer iron cores, but of particular importance is low iron loss.

From this perspective, it is also important to have a low iron loss value as a required characteristic of the directional electromagnetic steel sheet that is the iron core material. A high magnetic flux density is also necessary to reduce copper loss by reducing the excitation current in the transformer. This magnetic flux density is evaluated by the magnetic flux density $B8(T)$ at a magnetizing force of 800 A/m. In general, B8 increases as the degree of preferred orientation toward the Goss orientation is higher. Electromagnetic steel plates with high magnetic flux density generally have low hysteresis loss and superior iron loss characteristics. To reduce transformer core loss, it is generally considered that iron loss of the directional electromagnetic steel sheet, which is the iron core material, should be reduced. In fact, in a single-phase excitation coil iron core transformer, the material iron loss and transformer core loss are nearly matched, so the transformer core loss can be reduced by reducing the iron loss of the material.

However, it is known that iron loss in transformers, especially in three-phase excitation transformers with three or five legs, is larger than material iron loss. The ratio of the iron loss value (transformer core loss) when electromagnetic steel plates are used as the iron core of a transformer to the iron loss value of the material as obtained by Epstein testing or the like is generally referred to as the building factor (BF) or distraction factor (DF). In other words, for three-phase excitation transformers with three or five legs, it is common for the BF to exceed 1. Furthermore, it has been noted that in three-phase excitation transformers, the reduction of iron loss in the iron core material does not necessarily lead to reduction of iron loss in the transformer. In particular, it is known that in an iron core using a material with a high integration degree toward the Goss orientation (highly oriented grain-oriented electrical steel sheet: HGO), such that B8 is 1.88 T or higher, the magnetic properties of the transformer itself may in fact deteriorate even if the magnetic properties of the material are good. This means that even if a grain-oriented electrical steel sheet with excellent magnetic properties is manufactured, it cannot be fully utilized in the actual transformer characteristics. As for properties of the material other than magnetic flux density B8, BF also changes due to various changes in properties, such as the magnitude of tension in the steel sheet coating or whether magnetic domain refining treatment is performed. BF also varies depending on the shape of the transformer iron core or the stacked overlap method of the steel sheet, thus changing the iron loss of the transformer.

In order to select the iron core material or design the iron core shape to maximize reduction of iron loss in the transformer iron core, it is necessary to predict the resulting transformer core loss. However, as mentioned above, transformer core loss varies under various conditions in the transformer and is not easy to predict.

One method is to predict iron loss analytically or empirically by constructing a database of iron loss test results for transformers manufactured in the past, or iron loss results from tests on model transformers or the like manufactured in a reduced size to simulate actual transformers.

For example, Patent Literature (PTL) 1 discloses a method for estimating transformer core loss using a multiple regression equation obtained by multiple regression and multiple correlation analysis, taking the transformer core loss as the dependent variable and the iron core width dimensions, iron core window frame dimensions, iron core window length dimensions, iron core stacking height dimensions, iron core sheet thickness dimensions, material iron loss value, and material magnetization characteristic value as independent variables.

Another common method is to estimate transformer core loss by numerical simulation of electromagnetic fields. Numerical simulation of electromagnetic fields, in which Maxwell's equations are analyzed using the finite element method, uses a series of numerical analysis tools, including the creation of a mesh model, time analysis using the finite element method, and analysis of the results, that are commercially available as software.

However, for accurate analysis of transformer iron cores made of grain-oriented electrical steel sheets, the electromagnetic properties used in the analysis must be appropriately selected. Generally, the electromagnetic field numerical method uses the magnetic properties obtained by a single plate magnetic test method or Epstein test method, which measure the magnetic flux density and the like in the same direction as the applied magnetic field direction, assuming that the magnetic flux density B and magnetic field strength H are parallel. The results obtained with these methods treat the mapping quantities (components) in the measurement direction as scalar values (one-dimensional magnetic properties). On the other hand, when a material such as a grain-oriented electrical steel sheet, which is extremely easily magnetized in one direction, is subjected to magnetization inclined toward the easy magnetization axis, which often occurs in transformer cores, or to rotational magnetization, then a spatial directional difference occurs between the magnetic flux density and the magnetic field strength vector. This spatial directional difference between the magnetic flux density and the magnetic field strength vector has a very large impact on the prediction result for iron loss in electromagnetic field analysis. However, the single plate magnetic test method or Epstein test method could not measure the spatial directional difference between the magnetic flux density and the magnetic field strength vector because, as described above, such methods measure the mapping quantities (components) in the measurement direction.

To address this issue, a method has been proposed to measure the magnetic field strength H and magnetic flux density B as vector quantities, utilizing the concept of two-dimensional magnetic properties, and to perform electromagnetic field analysis based on these measured vector quantities. As a modeling of two-dimensional magnetic properties (a model of vector magnetic properties), E&S modeling, for example, has been proposed (see, for example, PTL 2). Using these methods, it is possible to obtain more accurate transformer core loss than with conventional electromagnetic field analysis based on one-dimensional magnetic properties.

CITATION LIST

Patent Literature

PTL 1: JP S62-75351 A
PTL 2: JP 2004-184234 A

SUMMARY

(Technical Problem)

In the two-dimensional magnetic properties model, which takes magnetic field strength H and magnetic flux density B as vector quantities, a two-dimensional magnetic property measurement apparatus is used to measure the material magnetic properties, which are the basis for calculation, as described in Reference 1.
Reference 1: Enokizono, "Two-Dimensional Vector Magnetic Property", Journal of the Magnetics Society of Japan, vol. 27, No. 2, 2003

The magnetic field strength H is measured by the H coil in two orthogonal directions, and the magnetic flux density B is measured by probing coils in two orthogonal directions or a probe method. Measurements are also made under various elliptical magnetization conditions by changing the maximum magnetic flux density, ellipticity, or inclination angle. During electromagnetic field analysis, accurate magnetic property measurement of the iron core of a transformer or other equipment can be analyzed by performing analysis using two-dimensional magnetic properties, modeled using the vector magnetic property results for the magnetic field strength H and magnetic flux density B under various elliptical magnetization conditions measured in this way.

In the electromagnetic field analysis method characterized by taking the magnetic field strength H and magnetic flux density B as vector quantities, the accuracy of the results is determined by the accuracy of the magnetic field strength H and magnetic flux density B measurements obtained using a two-dimensional magnetic property measurement apparatus. However, a problem exists in that the measurement results under the aforementioned elliptical magnetization conditions vary greatly depending on whether the direction of rotation is clockwise (CW) or counterclockwise (CCW) when the elliptical magnetization is applied.

For example, the following References 2 and 3 report that the measured iron loss values differ significantly depending on whether the excitation by elliptical magnetization is clockwise (CW) or counterclockwise (CCW) when the object of measurement is a grain-oriented electrical steel sheet, or even a non-oriented electrical steel sheet with a high excitation magnetic flux density.

Reference 2: Watanabe, Yanase, Okazaki, "Two-dimensional magnetic properties of grain-oriented electrical steel sheets", Papers of Technical Meeting on Magnetics, IEE Japan, MAG-08-80, P19-24, 2008
Reference 3: Maeda, Shimoji, Todaka, Enokizono, "Examination of measurement methods under CCW/CW conditions in the high magnetic flux density region", Papers of Technical Meeting on Magnetics, IEE Japan, MAG-07-139, P1-4, 2007

In view of the above issues, the present disclosure proposes a method of generating a data set of two-dimensional magnetic properties for use in two-dimensional magnetic modeling in an electromagnetic field analysis method, so that the accuracy of analysis results can be improved in an electromagnetic field analysis method characterized by taking magnetic field strength H and magnetic flux density B as vector quantities. A method of analyzing an electromagnetic field using the generated data set of two-dimensional magnetic properties is also proposed.

(Solution to Problem)

The data set generation method according to an embodiment of the present disclosure is a method of acquiring two-dimensional magnetic properties for use in analyzing an electromagnetic field of an analysis target by taking magnetic field strength and magnetic flux density as vector quantities, the method including:

measuring a first magnetic field strength vector generated in the analysis target in response to first elliptical magnetization applied clockwise along an ellipse having a major axis and a minor axis with a predetermined axis ratio, the major axis being inclined at a first angle relative to a rolling direction of the analysis target;
measuring a second magnetic field strength vector generated in the analysis target in response to second elliptical magnetization applied counterclockwise along an ellipse having a major axis and a minor axis with the predetermined axis ratio, the major axis being inclined at a second angle relative to the rolling direction of the analysis target, the second angle being opposite in sign from the first angle;
calculating a first average magnetic field strength vector by averaging the first magnetic field strength vector and the second magnetic field strength vector;
calculating a first average magnetic flux density vector by averaging a first magnetic flux density vector corresponding to the first elliptical magnetization and a second magnetic flux density vector corresponding to the second elliptical magnetization; and
generating a data set of the two-dimensional magnetic properties that associates the first average magnetic field strength vector and the first average magnetic flux density vector with the predetermined axis ratio and the first angle.

An electromagnetic field analysis method according to an embodiment of the present disclosure includes: analyzing an electromagnetic field of an iron core by using the data set, generated by performing the aforementioned data set generation method, of two-dimensional magnetic properties combining the first average magnetic field strength vector and the first average magnetic flux density vector, the iron core using an analysis target having the two-dimensional magnetic properties identified by the data set.

A computer program according to an embodiment of the present disclosure is configured to cause a computer to execute each step of the aforementioned data set generation method or the aforementioned electromagnetic field analysis method.

(Advantageous Effect)

According to the data set generation method, electromagnetic field analysis method, and computer program in an embodiment of the present disclosure, the accuracy of analysis results of magnetic properties of magnetic bodies, such as the iron core of electrical equipment, mainly the iron core of a transformer, can be enhanced.

BRIEF DESCRIPTION OF THE DRAWINGS

In the accompanying drawings:

FIG. 1 is a block diagram illustrating an example configuration of an analysis system according to the present disclosure;
FIG. 2 is a diagram illustrating an example of the relationship between the magnetic flux density vector and the magnetic field strength vector;
FIG. 3A is a diagram illustrating an example of clockwise elliptical magnetization applied to an analysis target;
FIG. 3B is a graph illustrating an example of the measurement results of the magnetic field strength vector generated when the elliptical magnetization of FIG. 3A is applied to the analysis target;
FIG. 4A is a diagram illustrating the relationship between the easy direction of magnetization and the major axis direction of elliptical magnetization, which are inclined in opposite directions from each other with respect to the rolling direction of the analysis target;
FIG. 4B is a diagram that is line symmetrical with respect to FIG. 4A, with the rolling direction of the analysis target as the axis of symmetry;

FIG. 5A is a diagram illustrating the relationship between the easy direction of magnetization and the major axis direction of elliptical magnetization, which are inclined in the same direction with respect to the rolling direction of the analysis target;

FIG. 5B is a diagram that is line symmetrical with respect to FIG. 5A, with the rolling direction of the analysis target as the axis of symmetry;

FIG. 6 is a diagram illustrating an example of a transformer iron core to which the steel sheet that is the analysis target is applied; and

FIG. 7 is a flowchart illustrating an example of procedures in the data set generation method according to the present disclosure.

DETAILED DESCRIPTION

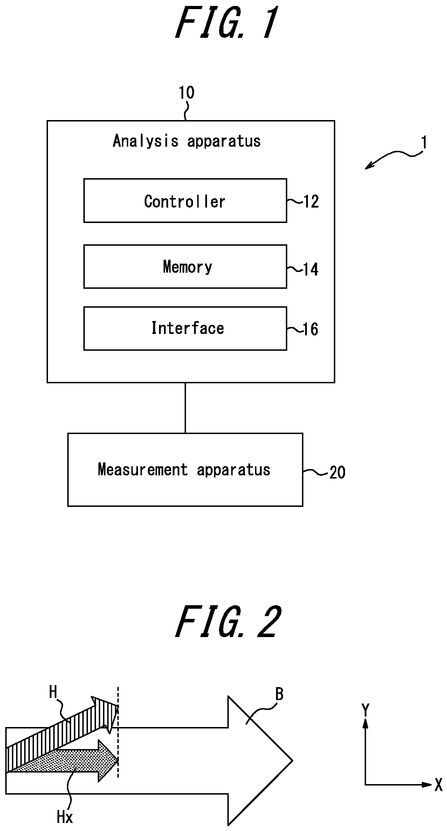

Embodiments of an analysis system 1 (see FIG. 1 and other drawings) and an analysis method according to the present disclosure are described below based on the drawings. Each drawing is schematic and may differ from reality. The following embodiments are examples of apparatuses or methods for embodying the technical ideas of the present disclosure, and the configurations are not specific to those listed below. In other words, various changes can be made to the technical concepts of the present disclosure within the technical scope of matter recited in the claims.

(Configuration Example of Analysis System 1)

As illustrated in FIG. 1, an analysis system 1 in an embodiment includes an analysis apparatus 10 and a measurement apparatus 20. The analysis system 1 is configured to enable analysis of two-dimensional magnetic properties of an analysis target, such as a grain-oriented electrical steel sheet or non-oriented electrical steel sheet.

The two-dimensional magnetic properties are properties that express the relationship between magnetic flux density and magnetic field strength not only in terms of magnitude but also in terms of direction by taking magnetic flux density and magnetic field strength each as a two-dimensional vector. As illustrated in FIG. 2, the magnetic flux density vector is represented as B. The magnetic field strength vector is represented as H. As illustrated in FIG. 2, the magnetic flux density vector B and the magnetic field strength vector H may point in different directions in a given analysis target. It is assumed that the magnetic flux density vector B is along the X-axis direction. It is assumed that the magnetic field strength vector H points in a different direction from the magnetic flux density vector B. In other words, it is assumed that spatial directional difference occurs between the magnetic field strength vector H and the magnetic flux density vector B.

$Hx$ represents the component of the magnetic field strength vector H in the X-axis direction. One-dimensional magnetic properties express the relationship between the magnitude of the magnetic flux density vector B, which points in the X-axis direction, and the component $Hx$ of the magnetic field strength vector H in the X-axis direction. In other words, the one-dimensional magnetic properties treat the mapping quantities (components) of the magnetic flux density and magnetic field strength in the measurement direction as scalar values.

When iron loss is predicted by analyzing the electromagnetic field of an analysis target in which a spatial directional difference occurs between the magnetic field strength vector H and the magnetic flux density vector B, the spatial directional difference has a significant impact on the prediction result for iron loss. By analyzing the electromagnetic field using two-dimensional magnetic properties, the analysis system 1 according to the present embodiment can analyze the electromagnetic field with higher precision than methods using one-dimensional magnetic properties (such as the single plate magnetic test method or Epstein test method).

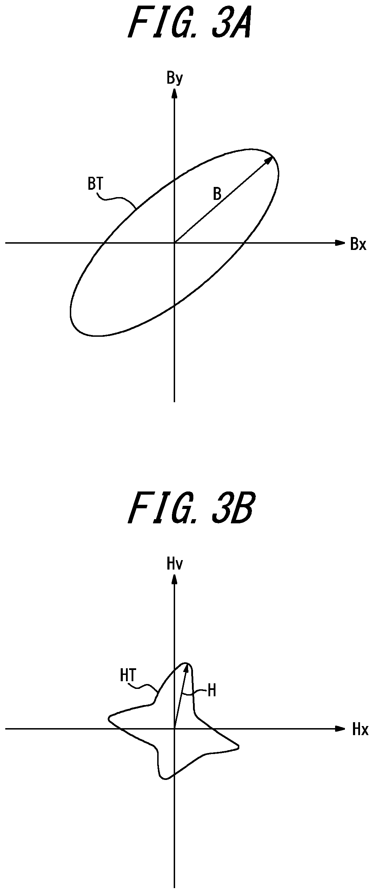

As illustrated in FIGS. 3A and 3B, the two-dimensional magnetic properties are represented as data associating the trajectory BT traced by the tip of the magnetic flux density vector B when the magnetic flux density applied to the analysis target is varied with the trajectory HT traced by the tip of the magnetic field strength vector H, which represents the magnetic field strength generated in the analysis target in response to the application of magnetic flux density. The horizontal and vertical axes in FIG. 3A represent the component in the X-axis direction ($Bx$) and the component in the Y-axis direction ($By$) of the magnetic flux density, respectively. The horizontal and vertical axes in FIG. 3B represent the component in the X-axis direction ($Hx$) and the component in the Y-axis direction ($Hy$) of the magnetic field strength, respectively.

In a case in which the respective components in the X-axis direction and the Y-axis direction of the magnetic flux density applied to the analysis target are expressed as sinusoidal waves, the trajectory BT of the tip of the magnetic flux density vector B can be an ellipse, as illustrated in FIG. 3A. The trajectory BT can also be a circle, depending on the amplitude of the respective components in the X-axis direction and Y-axis direction of the magnetic flux density. The trajectory BT can also be a straight line, depending on the phase of the respective components in the X-axis direction and Y-axis direction of the magnetic flux density. The magnetic flux when the trajectory BT of the tip of the magnetic flux density vector B becomes a curve, such as an ellipse or circle, is also referred to as rotational flux or rotational magnetization. The magnetic flux when the trajectory BT of the tip of the magnetic flux density vector B becomes a straight line is also referred to as alternating flux or alternating magnetization. Rotational magnetization is specified by the length Bm of the major axis of the ellipse representing the trajectory BT, the ratio $\alpha$ of the length of the minor axis to the length of the major axis of the ellipse, the angle $\theta$ that the major axis of the ellipse makes with respect to the X-axis direction, and the direction (clockwise (CW) or counterclockwise (CCW)) in which the tip of the magnetic flux density vector B moves along the trajectory BT. Alternating magnetization corresponds to the case in which $\alpha$ is zero in rotational magnetization.

<Analysis Apparatus 10>

The analysis apparatus 10 includes a controller 12, a memory 14, and an interface 16. The controller 12 may be configured to include at least one processor, such as a CPU (Central Processing Unit) or GPU (Graphics Processing Unit), to control and manage the various functions of the analysis apparatus 10. The controller 12 may be configured by a single processor or a plurality of processors. The processor configuring the controller 12 may realize the functions of the analysis apparatus 10 by reading and executing programs stored in the memory 14.

The memory 14 stores various information, data, and the like. The memory 14 may, for example, store programs executed by the controller 12, or data used in the processing executed by the controller 12, the results of processing, and the like. The memory 14 may function as a working memory of the controller 12. The memory 14 may include, but is not limited to, a semiconductor memory, for example. The memory 14 may, for example, be configured as the internal memory of the processor used as the controller 12 or as a hard disk drive (HDD) accessible from the controller 12. The memory 14 may be configured as a non-transitory readable medium. The memory 14 may be configured integrally with the controller 12 or may be configured separately from the controller 12.

The interface 16 may be configured to include a communication interface. The communication interface may be configured to communicate with other apparatuses, such as the measurement apparatus 20, by wired or wireless means. The communication interface may be configured to communicate with other apparatuses, such as the measurement apparatus 20, via a network. The communication interface may be configured to include an input/output port that inputs and outputs data to and from other apparatuses such as the measurement apparatus 20. The communication interface may communicate based on wired communication standards or wireless communication standards. Wireless communication standards may, for example, include cellular phone communication standards such as 3G, 4G, or 5G. Wireless communication standards may, for example, include IEEE 802.11 or Bluetooth® (Bluetooth is a registered trademark in Japan, other countries, or both). The communication interface may support one or more of these communication standards. The communication interface is not limited to these examples and may communicate with other apparatuses, such as the measurement apparatus 20, and input or output data based on various standards.

The interface 16 may be configured to include a display device. The display device may notify the user of information by outputting visual information such as text, graphics, or images. The display device may include a variety of displays, such as a liquid crystal display, for example.

The interface 16 may include an audio output device, such as a speaker, or a variety of other output devices. The analysis apparatus 10 may further include an input device that accepts input from the user. The input device may, for example, include a keyboard or physical keys, or may include pointing devices such as a touch panel, touch sensor, or mouse. The input device is not limited to these examples and may include a variety of other devices.

<Measurement Apparatus 20>

The measurement apparatus 20 includes a magnetic flux application unit that applies rotational magnetization (rotational magnetic flux) to the analysis target and a magnetic field measurement unit that measures the magnetic field strength generated in the analysis target to which the rotational magnetization is applied. The magnetic field measurement unit may be configured to include H coils located in two orthogonal directions with respect to the analysis target. The measurement apparatus 20 may use the magnetic flux density value generated by the magnetic flux application unit as is. The measurement apparatus 20 may further include a magnetic flux density measurement unit that measures the magnetic flux density actually applied to the analysis target. The magnetic flux density measurement unit may be configured to include probing coils located in two orthogonal directions with respect to the analysis target or may be configured to measure the magnetic flux density using a probe method.

The measurement apparatus 20 may be controlled by the analysis apparatus 10. The analysis apparatus 10 may control the rotational magnetization applied to the analysis target by the magnetic flux application unit. The analysis apparatus 10 may acquire the measurement results from the magnetic field measurement unit or the magnetic flux density measurement unit.

(Operation Example of Analysis System 1)

An example of the operation of the analysis system 1 is described below. In the analysis system 1, the controller 12 of the analysis apparatus 10 acquires data representing the relationship between the magnetic flux density vector B and the magnetic field strength vector H as the two-dimensional magnetic properties of the analysis target. The two-dimensional magnetic properties of the analysis target are expressed as a combination of magnetic flux density vectors B in at least two directions and the magnetic field strength vector H corresponding to each magnetic flux density vector B. In the present embodiment, the two-dimensional magnetic properties of the analysis target are assumed to be represented so that the magnetic flux density vector B becomes rotational magnetization. The data representing the combination of the magnetic flux density vector B and the magnetic field strength vector H is also referred to as the data set of two-dimensional magnetic properties.

The data set of the two-dimensional magnetic properties of the analysis target is, as described above, a combination of the magnetic flux density vector B applied to the analysis target and the magnetic field strength vector H generated in response to the application of the magnetic flux density vector B.

It is assumed here that the analysis target is a steel sheet. Depending on whether the direction of rotational magnetization applied to the analysis target is clockwise (CW) or counterclockwise (CCW), the magnetic field strength vector H generated in the analysis target may differ. Specifically, we discovered that when the major axis direction of the rotational magnetization of the ellipse and the easy direction of magnetization of the steel sheet are different, the measurement result for the magnetic field strength vector H differs significantly between application of clockwise rotational magnetization and application of counterclockwise rotational magnetization. Different measurement results for the magnetic field strength vector H result in different values of iron loss calculated by electromagnetic field analysis using a data set of two-dimensional magnetic properties based on those measurement results.

When the major axis direction of the rotational magnetization is inclined in the clockwise direction relative to the easy direction of magnetization of the steel sheet, the value of iron loss calculated using the data set of two-dimensional magnetic properties obtained by applying counterclockwise rotational magnetization is larger than the value of iron loss calculated using the data set of two-dimensional magnetic properties obtained by applying clockwise rotational magnetization. Conversely, when the major axis direction of the rotational magnetization is inclined in the counterclockwise direction relative to the easy direction of magnetization of the steel sheet, the value of iron loss calculated using the data set of two-dimensional magnetic properties obtained by applying clockwise rotational magnetization is larger than the value of iron loss calculated using the data set of two-dimensional magnetic properties obtained by applying counterclockwise rotational magnetization.

The difference in the value of iron loss depending on the direction of rotational magnetization depends on whether the direction of the magnetic flux density vector B passes through the easy direction of magnetization of the steel sheet while the magnetic flux density vector B changes from a direction that is close to the easy direction of magnetization and that is easy to magnetize (major axis direction) to a direction that is away from the easy direction of magnetization and that is difficult to magnetize (minor axis direction), or the direction of the magnetic flux density vector B passes through the easy direction of magnetization of the steel sheet while the magnetic flux density vector B changes from a direction that is away from the easy direction of magnetization and that is difficult to magnetize (minor axis direction) to a direction that is close to the easy direction of magnetization and that is easy to magnetize (major axis direction). In other words, the magnetic field strength generated by the application of magnetization differs depending on whether the direction of the magnetic flux density vector B passes through the easy direction of magnetization first when changing from a direction that is close to the easy direction of magnetization and that is easy to magnetize (major axis direction) to point in a direction that is away from the easy direction of magnetization and that is difficult to magnetize (minor axis direction), or after pointing in the minor axis direction.

One of the reasons why the magnetic field strength generated by rotational magnetization (rotational magnetic flux) differs depending on the direction of rotation is thought to be that the required magnetic field strength differs for the magnetic flux density vector of rotational magnetization (rotational magnetic flux) to move from a direction that is close to the easy direction of magnetization and that is easy to magnetize (major axis direction) to a direction that is away from the easy direction of magnetization and that is difficult to magnetize (minor axis direction). At the time when rotational magnetization (rotational magnetic flux) is applied to a steel sheet and the magnetization inside the steel sheet is directed from the major axis direction to the minor axis direction, if the easy direction of magnetization exists in that direction, a small magnetic field strength in that direction suffices, since the easy direction of magnetization is passed through at the beginning of rotation, and the magnetic field strength vector H does not need to be rotated so much in the minor axis direction with a phase difference relative to the vector B. As a result, the spatial directional difference between the magnetic flux density vector B and the magnetic field strength vector H is reduced. The smaller spatial directional difference between the magnetic flux density vector B and the magnetic field strength vector H results in smaller iron loss. This is because iron loss is calculated as the area of the hysteresis loop, and the larger the difference between the magnetic flux density vector B and the magnetic field strength vector H, the greater the iron loss. Conversely, when passing through the easy direction of magnetization after the minor axis direction is faced, the easy direction of magnetization is not passed through at the beginning of rotation. It is thought that the effect of reducing the spatial directional difference between the magnetic flux density vector B and the magnetic field strength vector H is therefore not achieved, and the iron loss increases.

It is difficult to determine the relationship between the rolling direction of a steel sheet and the easy direction of magnetization in advance. This is because in a grain-oriented electrical steel sheet, there is a deviation of a few degrees in the easy direction of magnetization of the secondary recrystallized grains that constitute the sheet. Another reason is that the secondary recrystallized grains are relatively large, giving rise to local variation in the easy direction of magnetization itself.

Since the easy direction of magnetization can differ from the rolling direction, it is difficult to know in advance whether the easy direction of magnetization of a steel sheet is inclined clockwise or counterclockwise relative to the rolling direction. Therefore, in the analysis system 1 according to the present embodiment, the controller 12 of the analysis apparatus 10 acquires the measurement result of the magnetic field strength vector H when clockwise rotational magnetization is applied to the analysis target and the measurement result of the magnetic field strength vector H when counterclockwise rotational magnetization is applied to the analysis target. The controller 12 generates a data set of two-dimensional magnetic properties for the analysis target by averaging the measurement result of the magnetic field strength vector H corresponding to clockwise rotational magnetization and the measurement result of the magnetic field strength vector H corresponding to counterclockwise rotational magnetization, and associating the average with the magnetic flux density vector B applied to the analysis target. By averaging the clockwise and counterclockwise results, the effect that the difference in the direction of rotation of the rotational magnetization has on the measurement result for the magnetic field strength vector can be reduced.

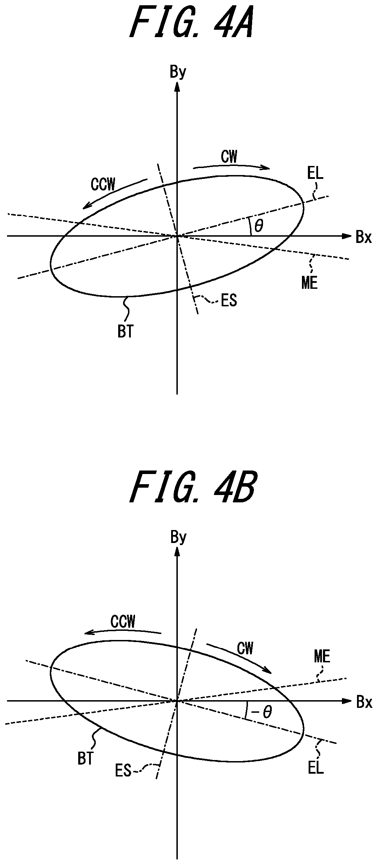

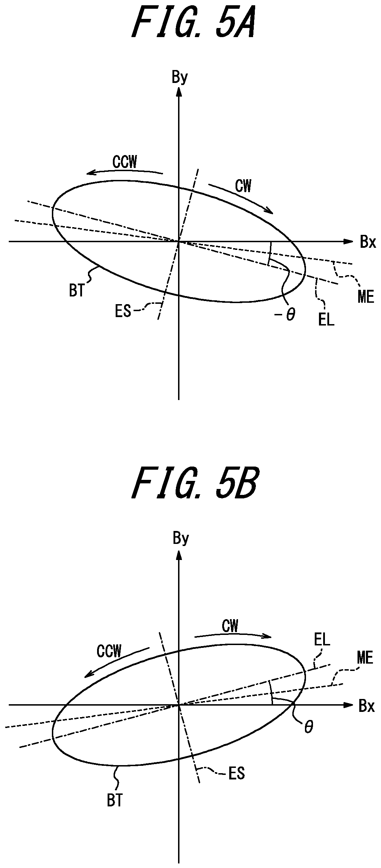

Specifically, using the measurement apparatus 20, the controller 12 may apply clockwise (CW) or counterclockwise (CCW) rotational magnetization to the analysis target along the trajectory BT of an ellipse having a major axis EL and minor axis ES, as illustrated in FIGS. 4A and 4B and in FIGS. 5A and 5B. The horizontal axis in FIGS. 4A and 4B and FIGS. 5A and 5B represents the X-axis component (Bx) of the magnetic flux density vector B applied as rotational magnetization to the analysis target. The vertical axis represents the Y-axis component (By). It is assumed that in the measurement apparatus 20, the steel sheet is arranged so that the rolling direction coincides with the X-axis direction. In FIG. 4A, the easy magnetization direction ME of the steel sheet is assumed to be inclined clockwise from the rolling direction (X-axis direction). The direction of the major axis EL is assumed to be inclined at an angle $\theta$ with respect to the rolling direction of the steel sheet (X-axis direction). In FIG. 4B, the easy magnetization direction ME of the steel sheet is assumed to be inclined counterclockwise from the rolling direction (X-axis direction). The direction of the major axis EL is assumed to be inclined at an angle -0 with respect to the rolling direction of the steel sheet (X-axis direction). In FIG. 5A, the easy magnetization direction ME of the steel sheet is assumed to be inclined clockwise from the rolling direction (X-axis direction). The direction of the major axis EL is assumed to be inclined at an angle $-\theta$ with respect to the rolling direction of the steel sheet (X-axis direction). In FIG. 5B, the easy magnetization direction ME of the steel sheet is assumed to be inclined counterclockwise from the rolling direction (X-axis direction). The direction of the major axis EL is assumed to be inclined at an angle $\theta$ with respect to the rolling direction of the steel sheet (X-axis direction).

In the trajectory BT of rotational magnetization illustrated in FIGS. 4A and 4B, the direction in which the major axis EL is inclined from the X-axis direction and the direction in which the easy direction of magnetization is inclined from the X-axis direction are opposite each other. The configurations depicted in FIG. 4A and FIG. 4B are line symmetrical with respect to the X-axis. Therefore, an equivalent relationship exists between the case of applying clockwise (CW) rotational magnetization in the configuration in FIG. 4A and counterclockwise (CCW) rotational magnetization in the configuration in FIG. 4B.

On the other hand, in the trajectory BT of rotational magnetization illustrated in FIGS. 5A and 5B, the direction in which the major axis EL is inclined from the X-axis direction and the direction in which the easy direction of magnetization is inclined from the X-axis direction are the same. The configurations depicted in FIG. 5A and FIG. 5B are line symmetrical with respect to the X-axis. Therefore, an equivalent relationship exists between the case of applying clockwise (CW) rotational magnetization in the configuration in FIG. 5A and counterclockwise (CCW) rotational magnetization in the configuration in FIG. 5B.

As described above, it is difficult to know in advance how the easy direction of magnetization is inclined with respect to the rolling direction. Even if the relationship between the easy direction of magnetization and the rolling direction were known, the relationship between the major axis direction of rotational magnetization and the easy direction of magnetization could become unknown due to angular misalignment when the analysis target is set on the measurement apparatus 20. However, regardless of whether the easy direction of magnetization is inclined clockwise or counterclockwise with respect to the rolling direction, the influence of the direction of rotation on the measurement result for the magnetic field strength vector H is reduced by applying two types of rotational magnetization exhibiting line symmetry with respect to the X-axis and averaging the measurement result for the magnetic field strength vector H generated in each case. Specifically, the controller 12 averages the measurement result for the magnetic field strength vector H obtained by applying clockwise (CW) rotational magnetization along the trajectory BT depicted in FIG. 4A and the measurement result for the magnetic field strength vector H obtained by applying counterclockwise (CCW) rotational magnetization along the trajectory BT depicted in FIG. 5A. The magnetic field strength vector calculated by averaging is also referred to as the average magnetic field strength vector.

In the configurations illustrated in FIGS. 4A and 5A, the easy direction of magnetization is inclined clockwise with respect to the X-axis direction. The average magnetic field strength vector when the easy direction of magnetization is inclined clockwise with respect to the X-axis direction is therefore expressed as Hcw. As illustrated in FIG. 4A, the angle at which the major axis direction is inclined counterclockwise with respect to the X-axis direction is represented by $\theta$. The measurement result for the magnetic field strength vector H obtained by applying clockwise (CW) rotational magnetization along the trajectory BT illustrated in FIG. 4A is expressed as H(Bm, $\alpha$, $\theta$, CW). Here, Bm is the maximum magnetic flux density. As illustrated in FIG. 5A, the angle at which the major axis direction is inclined clockwise with respect to the X-axis direction is represented by -0. The measurement result for the magnetic field strength vector H obtained by applying counterclockwise (CCW) rotational magnetization along the trajectory BT illustrated in FIG. 5A is expressed as H(Bm, $\alpha$, -0, CCW). Hew is calculated as the average of H(Bm, $\alpha$, $\theta$, CW) and H(Bm, $\alpha$, -0, CCW). Since the clockwise (CW) and counterclockwise (CCW) effects are reduced by averaging, Hew is expressed as Hcw(Bm, $\alpha$, $\theta$). $\alpha$ is also referred to as the predetermined axis ratio. $\theta$ is also referred to as the first angle, and -$\theta$ as the second angle. The first and second angles are opposite in sign from each other. The rotational magnetization applied clockwise (CW) along the trajectory BT illustrated in FIG. 4A is also referred to as the first elliptical magnetization. The rotational magnetization applied counterclockwise (CCW) along the trajectory BT illustrated in FIG. 5A is also referred to as the second elliptical magnetization. The magnetic field strength vector H when the first elliptical magnetization is applied is also referred to as the first magnetic field strength vector. The magnetic field strength vector H when the second elliptical magnetization is applied is also referred to as the second magnetic field strength vector.

The X-axis component and Y-axis component of Hew are represented as $H_{x\text{-}CW}$ and $H_{y\text{-}CW}$, respectively. The X-axis component and Y-axis component of H(Bm, $\alpha$, $\theta$, CW) are represented as $H_x$(Bm, $\alpha$, $\theta$, CW) and $H_y$(Bm, $\alpha$, $\theta$, CW), respectively. The X-axis component and Y-axis component of H(Bm, $\alpha$, -0, CCW) are represented as $H_x$(Bm, $\alpha$, -0, CCW) and $H_y$(Bm, $\alpha$, -0, CCW), respectively. The calculation results of $H_{x\text{-}CW}$ and $H_{y\text{-}CW}$ are expressed by the following Equation (1). For $H_{x\text{-}CW}$, since the components have the same sign in the X-axis direction, the average is calculated by adding and dividing by 2. For $H_{y\text{-}CW}$, since the components have opposite signs in the Y-axis direction due to line symmetry, the average is calculated by subtracting and dividing by 2.

$$H_{x-CW}(B_m, \alpha, \theta) = \{H_x(B_m, \alpha, \theta, CW) + H_x(B_m, \alpha, -\theta, CCW)\}/2$$
$$H_{y-CW}(B_m, \alpha, \theta) = \{H_y(B_m, \alpha, \theta, CW) - H_y(B_m, \alpha, -\theta, CCW)\}/2 \qquad (1)$$

The controller 12 may calculate the magnetic flux density vector B applied to the analysis target based on the rotational magnetization (rotational flux) applied to the analysis target. The controller 12 may acquire the measurement results of the magnetic flux density vector B from the measurement apparatus 20. The controller 12 may calculate the average magnetic flux density vector by averaging the measurement results of the magnetic flux density vector B corresponding to each of the first elliptical magnetization and second elliptical magnetization used to calculate the average magnetic field strength vector. The controller 12 may generate a data set of two-dimensional magnetic properties by associating the average magnetic field strength vector and the average magnetic flux density vector. The magnetic flux density vector B corresponding to the first elliptical magnetization is also referred to as the first magnetic flux density vector. The magnetic flux density vector B corresponding to the second elliptical magnetization is also referred to as the second magnetic flux density vector.

The measurement result for the magnetic flux density vector B when clockwise (CW) rotational magnetization is applied along the trajectory BT illustrated in FIG. 4A is expressed as B(Bm, $\alpha$, $\theta$, CW). The measurement result for the magnetic flux density vector B when counterclockwise (CCW) rotational magnetization is applied along the trajectory BT illustrated in FIG. 5A is expressed as B(Bm, $\alpha$, -0, CCW). The average magnetic field strength vector Bcw corresponding to the average magnetic field strength vector Hcw is calculated as the average of B(Bm, $\alpha$, $\theta$, CW) and B(Bm, $\alpha$, -0, CCW). The X-axis component and Y-axis component of Bcw are represented as $B_{x\text{-}CW}$ and $B_{y\text{-}CW}$, respectively. The X-axis component and Y-axis component of B(Bm, $\alpha$, $\theta$, CW) are represented as $B_x$(Bm, $\alpha$, $\theta$, CW) and $B_y$(Bm, $\alpha$, $\theta$, CW), respectively. The X-axis component and Y-axis component of B(Bm, $\alpha$, -0, CCW) are represented as $B_x$(Bm, $\alpha$, -0, CCW) and $B_y$(Bm, $\alpha$, -0, CCW), respectively. The calculation results of $B_{x\text{-}CW}$ and $B_{y\text{-}CW}$ are expressed by the following Equation (2). For $B_{x\text{-}CW}$, since the components have the same sign in the X-axis direction, the average is calculated by adding and dividing by 2. For $B_{y\text{-}CW}$, since the components have opposite signs in the Y-axis direction due to line symmetry, the average is calculated by subtracting and dividing by 2.

$$B_{x-CW}(B_m, \alpha, \theta) = \{B_x(B_m, \alpha, \theta, CW) + B_x(B_m, \alpha, -\theta, CCW)\}/2$$
$$B_{y-CW}(B_m, \alpha, \theta) = \{B_y(B_m, \alpha, \theta, CW) - B_y(B_m, \alpha, -\theta, CCW)\}/2 \qquad (2)$$

The controller 12 may calculate the average magnetic field strength vector and the average magnetic flux density vector based on the measurement results obtained when the rotational magnetization illustrated in FIGS. 4B and 5B is applied.

In the configurations illustrated in FIGS. 4B and 5B, the easy direction of magnetization is inclined counterclockwise with respect to the X-axis direction. The average magnetic field strength vector when the easy direction of magnetization is inclined clockwise with respect to the X-axis direction is therefore expressed as Hccw. As illustrated in FIG. 5B, the angle at which the major axis direction is inclined counterclockwise with respect to the X-axis direction is represented by $\theta$. The measurement result for the magnetic field strength vector H obtained by applying counterclockwise (CCW) rotational magnetization along the trajectory BT illustrated in FIG. 5B is expressed as H(Bm, $\alpha$, $\theta$, CCW). As illustrated in FIG. 4B, the angle at which the major axis direction is inclined clockwise with respect to the X-axis direction is represented by -0. The measurement result for the magnetic field strength vector H obtained by applying clockwise (CW) rotational magnetization along the trajectory BT illustrated in FIG. 4B is expressed as H(Bm, $\alpha$, -0, CW). Hccw is calculated as the average of H(Bm, $\alpha$, $\theta$, CCW) and H(Bm, $\alpha$, -0, CW). Since the clockwise (CW) and counterclockwise (CCW) effects are reduced by averaging, Hccw is expressed as Hccw(Bm, $\alpha$, $\theta$). The rotational magnetization applied counterclockwise (CCW) along the trajectory BT illustrated in FIG. 5B is also referred to as the third elliptical magnetization. The rotational magnetization applied clockwise (CW) along the trajectory BT illustrated in FIG. 4B is also referred to as the fourth elliptical magnetization. The magnetic field strength vector H when the third elliptical magnetization is applied is also referred to as the third magnetic field strength vector. The magnetic field strength vector H when the fourth elliptical magnetization is applied is also referred to as the fourth magnetic field strength vector.

The X-axis component and Y-axis component of Hccw are represented as $H_{x\text{-}CCW}$ and $H_{y\text{-}CCW}$, respectively. The X-axis component and Y-axis component of H(Bm, $\alpha$, $\theta$, CCW) are represented as $H_x$(Bm, $\alpha$, $\theta$, CCW) and $H_y$(Bm, $\alpha$, $\theta$, CCW), respectively. The X-axis component and Y-axis component of H(Bm, $\alpha$, -0, CW) are represented as $H_x$(Bm, $\alpha$, -0, CW) and $H_y$(Bm, $\alpha$, -0, CW), respectively. The calculation results of $H_{x\text{-}CCW}$ and $H_{y\text{-}CCW}$ are expressed by the following Equation (3). For $H_{x\text{-}CCW}$, since the components have the same sign in the X-axis direction, the average is calculated by adding and dividing by 2. For $H_{y\text{-}CCW}$, since the components have opposite signs in the Y-axis direction due to line symmetry, the average is calculated by subtracting and dividing by 2.

$$H_{x-CCW}(B_m, \alpha, \theta) = \{H_x(B_m, \alpha, \theta, CCW) + H_x(B_m, \alpha, -\theta, CW)\}/2$$
$$H_{y-CCW}(B_m, \alpha, \theta) = \{H_y(B_m, \alpha, \theta, CCW) - H_y(B_m, \alpha, -\theta, CW)\}/2 \tag{3}$$

The controller 12 may calculate the average magnetic flux density vector by averaging the measurement results of the magnetic flux density vector B corresponding to each of the third elliptical magnetization and fourth elliptical magnetization used to calculate the average magnetic field strength vector. The controller 12 may generate a data set of two-dimensional magnetic properties by associating the average magnetic field strength vector and the average magnetic flux density vector. The magnetic flux density vector B corresponding to the third elliptical magnetization is also referred to as the third magnetic flux density vector. The magnetic flux density vector B corresponding to the fourth elliptical magnetization is also referred to as the fourth magnetic flux density vector.

The measurement result for the magnetic flux density vector B when counterclockwise (CCW) rotational magnetization is applied along the trajectory BT illustrated in FIG. 5B is expressed as B(Bm, $\alpha$, $\theta$, CCW). The measurement result for the magnetic flux density vector B when clockwise (CW) rotational magnetization is applied along the trajectory BT illustrated in FIG. 4B is expressed as B(Bm, $\alpha$, -0, CW). The average magnetic flux density vector Bccw corresponding to the average magnetic field strength vector Hccw is calculated as the average of B(Bm, $\alpha$, $\theta$, CW) and B(Bm, $\alpha$, -0, CCW). The X-axis component and Y-axis component of Bccw are represented as $B_{x\text{-}CCW}$ and $B_{y\text{-}CCW}$, respectively. The X-axis component and Y-axis component of B(Bm, $\alpha$, v, CCW) are represented as $B_x$(Bm, $\alpha$, $\theta$, CCW) and $B_y$(Bm, $\alpha$, $\theta$, CCW), respectively. The X-axis component and Y-axis component of B(Bm, $\alpha$, -0, CW) are represented as $B_x$(Bm, $\alpha$, -0, CW) and $B_y$(Bm, $\alpha$, -0, CW), respectively. The calculation results of $B_{x\text{-}CCW}$ and $B_{y\text{-}CCW}$ are expressed by the following Equation (4). For $B_{x\text{-}CCW}$, since the components have the same sign in the X-axis direction, the average is calculated by adding and dividing by 2. For $B_{y\text{-}CCW}$, since the components have opposite signs in the Y-axis direction due to line symmetry, the average is calculated by subtracting and dividing by 2.

$$B_{x-CCW}(B_m, \alpha, \theta) = \{B_x(B_m, \alpha, \theta, CCW) + B_x(B_m, \alpha, -\theta, CW)\}/2$$
$$B_{y-CCW}(B_m, \alpha, \theta) = \{B_y(B_m, \alpha, \theta, CCW) - B_y(B_m, \alpha, -\theta, CW)\}/2 \tag{4}$$

The combination of the first and second elliptical magnetizations may be replaced by the combination of the third and fourth elliptical magnetizations. The controller 12 may acquire the respective measurement results when the first, second, third, and fourth elliptical magnetizations are applied. The controller 12 may calculate the average magnetic field strength vector by averaging the respective measurement results for the first, second, third, and fourth magnetic field strength vectors. In this way, the effect of the rotation direction of the rotational magnetization can be further reduced.

The controller 12 may calculate the average magnetic field strength vector and the average magnetic flux density vector in various combinations with different values of Bm, $\alpha$, and $\theta$, respectively, and generate a data set of two-dimensional magnetic properties associating the average magnetic field strength vector and the average magnetic flux density vector. The controller 12 can acquire the data of alternating magnetization (alternating flux) by setting the value of $\alpha$ to 0.

The controller 12 may generate a data set of two-dimensional magnetic properties, including the case in which the value of $\theta$ is set to 0. When the value of $\theta$ is 0, the first elliptical magnetization and the fourth elliptical magnetization are equivalent. The second elliptical magnetization and the third elliptical magnetizations are also equivalent.

The controller 12 may set the first angle represented by $\theta$ to at least two different values, calculate the average magnetic field strength vector and the average magnetic flux density vector for each set value of the first angle, and add their combination to the data set of two-dimensional magnetic properties.

By performing electromagnetic field analysis based on the data set of two-dimensional magnetic properties of the analysis target generated as described above, the controller 12 can predict the excitation characteristics of the iron core when the analysis target is used as the material of the iron core.

The controller 12 may perform both analysis based on the data set combining the average magnetic field strength vector and the average magnetic flux density vector calculated based on the first elliptical magnetization and the second elliptical magnetization, and analysis based on the data set combining the average magnetic field strength vector and the average magnetic flux density vector calculated based on the third elliptical magnetization and the fourth elliptical magnetization. The average magnetic field strength vector and the average magnetic flux density vector calculated based on the first elliptical magnetization and the second elliptical magnetization are also referred to as the first average magnetic field strength vector and the first average magnetic flux density vector, respectively. The average magnetic field strength vector and the average magnetic flux density vector calculated based on the third elliptical magnetization and the fourth elliptical magnetization are also referred to as the second average magnetic field strength vector and the second average magnetic flux density vector, respectively. The controller 12 may acquire, as a first analysis result, the result of the analysis based on the data set combining the first average magnetic field strength vector and the first average magnetic flux density vector. The controller 12 may acquire, as a second analysis result, the result of the analysis based on the data set combining the second average magnetic field strength vector and the second average magnetic flux density vector. The controller 12 may acquire an average analysis result by averaging the first analysis result and the second analysis result. In this way, the accuracy of electromagnetic field analysis can be enhanced.

EXAMPLES

The E&S model or the E&SS model, for example, can be used as an electromagnetic field analysis method. In the present Examples, electromagnetic field analysis using the E&S model is described. In the E&S model, in order to express magnetic properties in one dimension (alternating condition) and two dimensions (rotational flux condition) taking hysteresis into account, the magnetic field strength H is modeled in the following Equations (5) and (6) in relation not only to the magnetic flux density B but also to the derivative of the magnetic flux density B, which represents the increase or decrease in the magnetic flux density B.

$$H_x = v_{xr} B_x + v_{xi} \frac{\partial B_x}{\partial t} \qquad (5)$$

$$H_y = v_{yr} B_y + v_{yi} \frac{\partial B_y}{\partial t} \qquad (6)$$

The magnetoresistance coefficients $v_{xr}$, $v_{xi}$, $v_{yr}$, and $v_{yi}$ in the above Equations are determined based on the measurement results of a BH loop (two-dimensional magnetic property data set) obtained by the measurement apparatus 20. Specifically, the magnetoresistance coefficients are determined under the combined conditions of the maximum magnetic flux density Bm, ellipticity $\alpha$ (axis ratio), and inclination angle $\theta$, which are changed to various values. The range over which the maximum magnetic flux density Bm, ellipticity $\alpha$, and inclination angle $\theta$ is changed, and in what increments of measurement, is not specified, as this depends on the design of the target electrical equipment (transformer, motor, or the like). In general, the maximum magnetic flux density is preferably measured between 0.5 T and 2.0 T (tesla) in 0.1 T increments, the ellipticity between 0 and 1 in 0.05 increments, and the inclination angle between -180° and +180° (-90° and +90° when symmetry is considered) in 5° increments.

The average magnetic field strength vector and the average magnetic flux density vector are calculated as described above for the results obtained from the aforementioned measurements, and the magnetoresistance coefficients $v_{xr}$, $v_{xi}$, $v_{yr}$, and $v_{yi}$ are determined based on the calculation results.

The obtained data sets of magnetoresistance coefficients $v_{xr}$, $v_{xi}$, $v_{yr}$, and $v_{yi}$ include the data set determined from the combination of the average magnetic field strength vector Hew and the average magnetic flux density vector Bcw, and the data set determined from the combination of the average magnetic field strength vector Hccw and the average magnetic flux density vector Bccw. The controller 12 performs electromagnetic field analysis based on the relationship between the vector quantities of the magnetic field strength H and the magnetic flux density B modeled by the respective magnetoresistance coefficient data sets. At that time, except for conditions such that magnetic property measurement has been performed to yield data, the relationship between the vector quantities of the magnetic field strength H and the magnetic flux density B is determined by coefficient interpolation of the magnetoresistance coefficients. In the present Examples, the method of electromagnetic field analysis may be, but is not limited to, analysis of Maxwell's equations by the finite element method. In addition to the finite element method, other discretization analysis methods may be used, such as the boundary element method. A method that can reference and analyze detailed shape information is suitable.

For magnetic property results (such as iron loss) obtained for each of the two data sets, CW and CCW, the results can be further averaged to obtain accurate results.

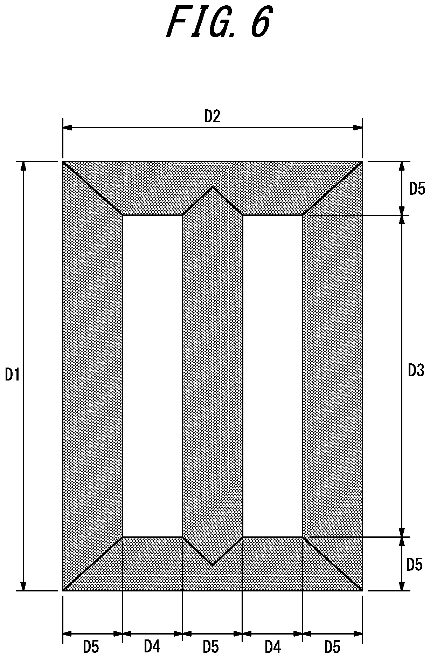

The accuracy of the electromagnetic field analysis was verified on a three-phase three-leg transformer iron core. First, as illustrated in FIG. 6 and Table 1, three-phase three-leg model transformer iron cores with five iron core shapes P1-P5 were produced using the four types of grain-oriented electrical steel sheets Q1-Q4 illustrated in Table 2.

[Table 1]

| Iron core shape | D1 (mm) | D2 (mm) | D3 (mm) | D4 (mm) | D5 (mm) |
|---|---|---|---|---|---|
| P1 | 1000 | 1000 | 600 | 200 | 200 |
| P2 | 700 | 750 | 400 | 150 | 150 |
| P3 | 960 | 840 | 600 | 150 | 180 |
| P4 | 940 | 760 | 700 | 200 | 120 |
| P5 | 550 | 550 | 350 | 125 | 100 |

[Table 2]

| Iron core material | Sheet thickness (mm) | Magnetic flux density B8 (T) | Iron loss W17/50 (W/kg) |
|---|---|---|---|
| Q1 | 0.30 | 1.95 | 0.97 |
| Q2 | 0.30 | 1.85 | 1.23 |
| Q3 | 0.23 | 1.94 | 0.67 |
| Q4 | 0.20 | 1.92 | 0.66 |

The transformer core loss was measured by a power meter method with 60 turns of winding on the legs of the iron core and three-phase excitation at a maximum magnetic flux density of 1.7 T (tesla) and a frequency of 50 Hz (hertz). The results are illustrated in Table 3.

Using the grain-oriented electrical steel sheets from which the transformer iron core was produced, 80 mm square two-dimensional magnetic property measurement samples were prepared as steel sheets to be the analysis targets. For each sample, the maximum magnetic flux density was measured from 0.5 to 1.95 T (tesla) in 0.05 T increments, the ellipticity from 0 to 0.8 in 0.05 increments, and the inclination angle from -180° to +180° in 5° increments, and from these results, the magnetoresistance coefficients $v_{xr}$, $v_{xi}$, $v_{yr}$, and $v_{yi}$ in the E&S model were obtained. At this time, the magnetoresistance coefficients $v_{xr}$, $v_{xi}$, $v_{yr}$, and $v_{yi}$ were obtained both for the case of averaging the result of applying clockwise rotational magnetization and the result of applying counterclockwise rotational magnetization, and the case of not calculating the average. Electromagnetic field analysis was performed based on the relationship between the vector quantities of the magnetic field strength H and the magnetic flux density B modeled using each of the magnetoresistance coefficients $v_{xr}$, $v_{xi}$, $v_{yr}$, and $v_{yi}$. The transformer core loss of the three-phase three-leg model transformer iron core, for which the aforementioned transformer core loss was actually measured, was then calculated. The calculation results are illustrated in Table 3.

[Table 3]

| | | | Actual measurement result | Excitation conditions (Bm: 1.7 T, f: 50 Hz) | | | |
|---|---|---|---|---|---|---|---|
| | | | | Analysis result of present disclosure | | Analysis result of Comparative Example | |
| Condition | Iron core shape | Iron core material | Transformer core loss (W/kg) | Transformer core loss (W/kg) | Difference from actual measurement (%) | Transformer core loss (W/kg) | Difference from actual measurement (%) |
| 1 | P1 | Q1 | 1.26 | 1.24 | -1.6 | 1.41 | 11.9 |
| 2 | P1 | Q2 | 1.51 | 1.50 | -0.7 | 1.13 | -25.2 |
| 3 | P1 | Q3 | 0.82 | 0.83 | 1.2 | 0.96 | 17.1 |
| 4 | P1 | Q4 | 0.79 | 0.79 | 0.0 | 0.81 | 2.5 |
| 5 | P2 | Q1 | 1.31 | 1.33 | 1.5 | 1.37 | 4.6 |
| 6 | P2 | Q2 | 1.59 | 1.61 | 1.3 | 1.16 | -27.0 |
| 7 | P2 | Q3 | 0.86 | 0.86 | 0.0 | 0.73 | -15.1 |
| 8 | P2 | Q4 | 0.83 | 0.84 | 1.2 | 0.89 | 7.2 |
| 9 | P3 | Q1 | 1.34 | 1.33 | -0.7 | 1.86 | 38.8 |
| 10 | P3 | Q2 | 1.64 | 1.64 | 0.0 | 1.55 | -5.5 |
| 11 | P3 | Q3 | 0.87 | 0.87 | 0.0 | 0.96 | 10.3 |
| 12 | P3 | Q4 | 0.84 | 0.84 | 0.0 | 0.9 | 7.1 |
| 13 | P4 | Q1 | 1.22 | 1.24 | 1.6 | 1.32 | 8.2 |
| 14 | P4 | Q2 | 1.48 | 1.48 | 0.0 | 1.3 | -12.2 |
| 15 | P4 | Q3 | 0.79 | 0.79 | 0.0 | 0.85 | 7.6 |
| 16 | P4 | Q4 | 0.77 | 0.76 | -1.3 | 0.82 | 6.5 |
| 17 | P5 | Q1 | 1.25 | 1.24 | -0.8 | 1.36 | 8.8 |
| 18 | P5 | Q2 | 1.50 | 1.49 | -0.7 | 1.28 | -14.7 |
| 19 | P5 | Q3 | 0.80 | 0.81 | 1.3 | 0.7 | -12.5 |
| 20 | P5 | Q4 | 0.77 | 0.77 | 0.0 | 0.99 | 28.6 |

The transformer core loss calculated using the method according to the present embodiment (the method of averaging the result of applying clockwise rotational magnetization and the result of applying counterclockwise rotational magnetization) was always calculated within 2% accuracy of the actually measured transformer core loss. The average difference from the actual measurement was 0.7%. In contrast, in the case of not calculating the average, the calculation accuracy was significantly worse under all conditions than in the case of applying the method according to the present embodiment. The average difference from the actual measurement was 13.6%.

(Example Procedures of Analysis Method)

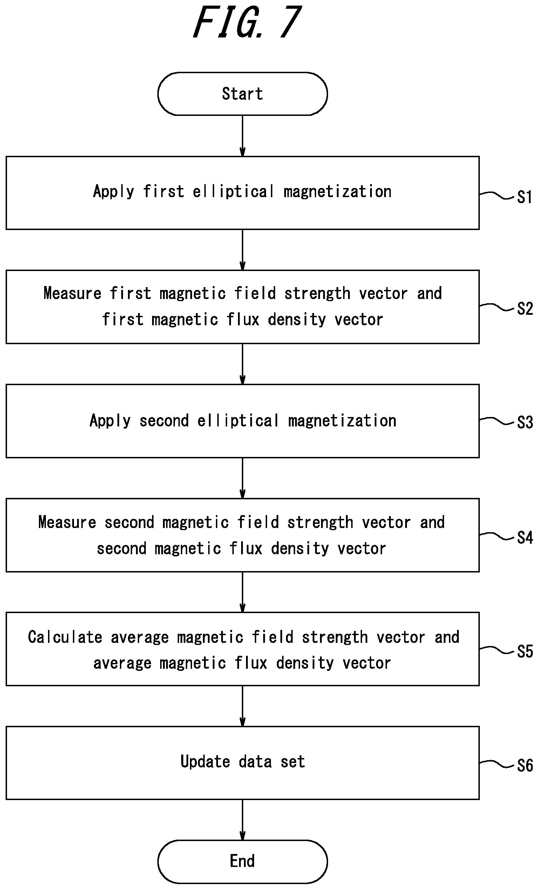

Example procedures of a data set generation method for generating a data set as an analysis method to be executed by the controller 12 of the analysis apparatus 10 in the analysis system 1 according to the present embodiment are described based on the procedures in the flowchart illustrated in FIG. 7. The data set generation method may be realized as a data set generation program or a computer program to be executed by a processor configuring the controller 12 or a computer configuring the analysis apparatus 10. The data set generation program or computer program may be stored on a non-transitory computer readable medium.

The controller 12 applies the first elliptical magnetization to the analysis target using the measurement apparatus 20 (step S1). The controller 12 measures the first magnetic field strength vector and the first magnetic flux density vector using the measurement apparatus 20 (step S2).

The controller 12 applies the second elliptical magnetization to the analysis target using the measurement apparatus 20 (step S3). The controller 12 measures the second magnetic field strength vector and the second magnetic flux density vector using the measurement apparatus 20 (step S4).

The controller 12 calculates the average magnetic field strength vector and the average magnetic flux density vector (step S5). The controller 12 updates the data set of two-dimensional magnetic properties by adding data combining the calculation results of the average magnetic field strength vector and the average magnetic flux density vector (step S6). After execution of the procedure in step S6, the controller 12 terminates execution of the procedures of the flowchart in FIG. 7.

As the analysis method, the controller 12 may execute an electromagnetic field analysis method that analyzes an electromagnetic field using the data set generated by the data set generation method. The electromagnetic field analysis method may be realized as an electromagnetic field analysis program or a computer program to be executed by a processor configuring the controller 12 or a computer configuring the analysis apparatus 10. The electromagnetic field analysis program or computer program may be stored on a non-transitory computer readable medium.

As described above, according to the analysis system 1, the analysis apparatus 10, and the analysis method of the present embodiment, the effect of the rotation direction of rotational magnetization on electromagnetic field analysis using two-dimensional magnetic properties can be reduced. Consequently, the accuracy of electromagnetic field analysis can be enhanced.

While embodiments of the present disclosure have been described with reference to the drawings and examples, it should be noted that various modifications and revisions may be implemented by those skilled in the art based on the present disclosure. Accordingly, such modifications and revisions are included within the scope of the present disclosure. For example, functions or the like included in each component, each step, or the like can be rearranged without logical inconsistency, and a plurality of components, steps, or the like can be combined into one or divided. Embodiments according to the present disclosure can also be realized as a program executed by a processor included in an apparatus or as a storage medium having the program recorded thereon. Such embodiments are also to be understood as included in the scope of the present disclosure.

REFERENCE SIGNS LIST

1 Analysis system
10 Analysis apparatus (12: Controller, 14: Memory, 16: Interface)
20 Measurement apparatus

**Claims**

1. A data set generation method of acquiring two-dimensional magnetic properties for use in analyzing an electromagnetic field of an analysis target by taking magnetic field strength and magnetic flux density as vector quantities, the data set generation method comprising:

   measuring a first magnetic field strength vector generated in the analysis target in response to first elliptical magnetization applied clockwise along an ellipse having a major axis and a minor axis with a predetermined axis ratio, the major axis being inclined at a first angle relative to a rolling direction of the analysis target;
   measuring a second magnetic field strength vector generated in the analysis target in response to second elliptical magnetization applied counterclockwise along an ellipse having a major axis and a minor axis with the predetermined axis ratio, the major axis being inclined at a second angle relative to the rolling direction of the analysis target, the second angle being opposite in sign from the first angle;
calculating a first average magnetic field strength vector by averaging the first magnetic field strength vector and the second magnetic field strength vector;
calculating a first average magnetic flux density vector by averaging a first magnetic flux density vector corresponding to the first elliptical magnetization and a second magnetic flux density vector corresponding to the second elliptical magnetization; and
generating a data set of the two-dimensional magnetic properties that associates the first average magnetic field strength vector and the first average magnetic flux density vector with the predetermined axis ratio and the first angle.

2. The data set generation method according to claim 1, wherein the calculating of the first average magnetic flux density vector includes measuring the first magnetic flux density vector and the second magnetic flux density vector.

3. The data set generation method according to claim 1, further comprising

measuring a third magnetic field strength vector generated in the analysis target in response to third elliptical magnetization applied counterclockwise along an ellipse having a major axis and a minor axis with the predetermined axis ratio, the major axis being inclined at the first angle relative to the rolling direction of the analysis target;
measuring a fourth magnetic field strength vector generated in the analysis target in response to fourth elliptical magnetization applied clockwise along an ellipse having a major axis and a minor axis with the predetermined axis ratio, the major axis being inclined at the second angle relative to the rolling direction of the analysis target;
calculating a second average magnetic field strength vector by averaging the third magnetic field strength vector and the fourth magnetic field strength vector;
calculating a second average magnetic flux density vector by averaging a third magnetic flux density vector corresponding to the third elliptical magnetization and a fourth magnetic flux density vector corresponding to the fourth elliptical magnetization; and
generating a data set of the two-dimensional magnetic properties that associates the second average magnetic field strength vector and the second average magnetic flux density vector with the predetermined axis ratio and the first angle.

4. The data set generation method according to claim 3, wherein the calculating of the second average magnetic flux density vector includes measuring the third magnetic flux density vector and the fourth magnetic flux density vector.

5. The data set generation method according to any one of claims 1 to 4, further comprising

setting the first angle to at least two different setting values, wherein
the generating of the data set of the two-dimensional magnetic properties includes adding, to the data set of the two-dimensional magnetic properties, the average magnetic field strength vector and the average magnetic flux density vector calculated for each setting value of the first angle, in association with each setting value.

6. An electromagnetic field analysis method comprising analyzing an electromagnetic field of an iron core by using the data set, generated by performing the data set generation method according to claim 1 or 2, of two-dimensional magnetic properties combining the first average magnetic field strength vector and the first average magnetic flux density vector, the iron core using an analysis target having the two-dimensional magnetic properties identified by the data set.

7. An electromagnetic field analysis method comprising analyzing an electromagnetic field of an iron core by using the data set, generated by performing the data set generation method according to claim 3 or 4, of two-dimensional magnetic properties combining the second average magnetic field strength vector and the second average magnetic flux density vector, the iron core using an analysis target having the two-dimensional magnetic properties identified by the data set.

8. An electromagnetic field analysis method comprising:

acquiring a first analysis result by analyzing an electromagnetic field of an iron core by using the data set, generated by performing the data set generation method according to claim 1 or 2, of two-dimensional magnetic properties combining the first average magnetic field strength vector and the first average magnetic flux density vector, the iron core using an analysis target having the two-dimensional magnetic properties identified by the data set;

acquiring a second analysis result by analyzing an electromagnetic field of an iron core by using the data set, generated by performing the data set generation method according to claim 3 or 4, of two-dimensional magnetic properties combining the second average magnetic field strength vector and the second average magnetic flux density vector, the iron core using an analysis target having the two-dimensional magnetic properties identified by the data set; and

averaging the first analysis result and the second analysis result to acquire an average analysis result.

9. A computer program configured to cause a computer to execute each step in the data set generation method according to any one of claims 1 to 4.

10. A computer program configured to cause a computer to execute each step in the data set generation method according to claim 5.

11. A computer program configured to cause a computer to execute each step in the electromagnetic field analysis method according to claim 6.

12. A computer program configured to cause a computer to execute each step in the electromagnetic field analysis method according to claim 7.

13. A computer program configured to cause a computer to execute each step in the electromagnetic field analysis method according to claim 8.

EP 4 498 105 A1

# FIG. 1

Analysis apparatus ~10

Controller ~12

Memory ~14

Interface ~16

1

Measurement apparatus ~20

# FIG. 2

H

Hx

B

Y

X

17

*FIG. 3A*

*FIG. 3B*

## FIG. 4A

## FIG. 4B

## *FIG. 5A*

## *FIG. 5B*

# FIG. 6

# FIG. 7

```
┌──────────────┐
│    Start     │
└──────────────┘
        │
        ▼
┌─────────────────────────────────────────┐
│    Apply first elliptical magnetization  │        S1
└─────────────────────────────────────────┘
        │
        ▼
┌─────────────────────────────────────────┐
│  Measure first magnetic field strength vector and │   S2
│      first magnetic flux density vector  │
└─────────────────────────────────────────┘
        │
        ▼
┌─────────────────────────────────────────┐
│   Apply second elliptical magnetization  │        S3
└─────────────────────────────────────────┘
        │
        ▼
┌─────────────────────────────────────────┐
│ Measure second magnetic field strength vector and │  S4
│     second magnetic flux density vector  │
└─────────────────────────────────────────┘
        │
        ▼
┌─────────────────────────────────────────┐
│ Calculate average magnetic field strength vector and │  S5
│     average magnetic flux density vector │
└─────────────────────────────────────────┘
        │
        ▼
┌─────────────────────────────────────────┐
│           Update data set               │        S6
└─────────────────────────────────────────┘
        │
        ▼
┌──────────────┐
│     End      │
└──────────────┘
```

## INTERNATIONAL SEARCH REPORT

International application No.

**PCT/JP2023/018326**

| A. | CLASSIFICATION OF SUBJECT MATTER |
|---|---|

*G01R 33/12*(2006.01)i; *G01N 27/72*(2006.01)i; *H01F 41/00*(2006.01)i
FI:   G01R33/12 Z; G01N27/72; H01F41/00 D

According to International Patent Classification (IPC) or to both national classification and IPC

| B. | FIELDS SEARCHED |
|---|---|

Minimum documentation searched (classification system followed by classification symbols)

G01R33/00-33/26; G01N27/72-27/9093; H01F41/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

IEEE Xplore; Wiley Online Library

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | 戸高孝；榎園正人, "ベクトル磁気特性を考慮した磁気特性解析による電気機器の最適構造化設計", 電気学会研究会資料 静止器回転機合同研究会, 社団法人電気学会, 27 January 2012, pp. 65-70 (TODAKA, Takashi. ENOKIZONO, Masato. Optimization of electrical machines through magnetic characteristic analysis considering vector magnetic properties. The Papers of Joint Technical Meeting on Static Apparatus and Rotating Machinery. The Institute of Electrical Engineers of Japan.)<br>p. 66, left column, lines 2-29, p. 67, right column, lines 7-17, p. 70, right column, lines 14-17, fig. 1-2 4 | 1-7, 9-12 |
| A | | 8, 13 |
| Y | 前田義隆；戸高孝；榎園正人, "高磁束密度領域における電磁鋼板のベクトル磁気特性測定", 電気学会論文誌A, 01 February 2011, vol. 131, no. 2, pp. 145-150, DOI: 10.1541/ieejfms.131.145 (MAEDA, Yoshitaka. TODAKA, Takashi. ENOKIZONO, Masato. Vector Magnetic Property Measurement in Magnetic Steel Sheets under High Magnetic Flux Density Conditions. IEEJ Transactions on Fundamentals and Materials.)<br>p. 145, right column, line 24 to p. 146, right column, line 5, p. 147, right column, line 21 to p. 148, left column, line 6, fig. 1-3, 5, table 1 | 1-7, 9-12 |

☑ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **12 July 2023** | **01 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2023/018326**

### C.    DOCUMENTS CONSIDERED TO BE RELEVANT

| Category* | Citation of document, with indication, where appropriate, of the relevant passages | Relevant to claim No. |
|---|---|---|
| A | MAEDA, Yoshitaka. SHIMOJI, Hiroyasu. TODAKA, Takashi. ENOKIZONO, Masato. Study of the Counterclockwise/Clockwise (CCW/CW) Rotational Losses Measured with a Two-dimensional Vector Magnetic Property Measurement System. IEEJ Transactions on Electrical and Electronic Engineering. March 2008, vol. 3, no. 2, pp. 222-228, DOI: 10.1002/tee.20258<br>entire text | 1-13 |
| A | WO 2019/151399 A1 (JFE STEEL CORPORATION) 08 August 2019 (2019-08-08)<br>entire text | 1-13 |
| A | WO 2019/151401 A1 (JFE STEEL CORPORATION) 08 August 2019 (2019-08-08)<br>entire text | 1-13 |
| P, A | CN 114707360 A (NANJING NORMAL UNIVERSITY) 05 July 2022 (2022-07-05)<br>entire text | 1-13 |

Form PCT/ISA/210 (second sheet) (January 2015)

International application No.

**PCT/JP2023/018326**

| Patent document cited in search report | | | Publication date (day/month/year) | Patent family member(s) | | | Publication date (day/month/year) |
|---|---|---|---|---|---|---|---|
| WO | 2019/151399 | A1 | 08 August 2019 | US | 2021/0043358 | A1 | |
| | | | | EP | 3726543 | A1 | |
| | | | | CA | 3086308 | A1 | |
| | | | | MX | 2020007993 | A | |
| | | | | KR | 10-2020-0103090 | A | |
| | | | | CN | 111656465 | A | |
| | | | | RU | 2741403 | C1 | |
| | | | | JP | 7028242 | B2 | |
| WO | 2019/151401 | A1 | 08 August 2019 | US | 2020/0373046 | A1 | |
| | | | | EP | 3734623 | A1 | |
| | | | | CA | 3088125 | A1 | |
| | | | | MX | 2020007951 | A | |
| | | | | KR | 10-2020-0103091 | A | |
| | | | | CN | 111670480 | A | |
| | | | | RU | 2741585 | C1 | |
| | | | | JP | 7028244 | B2 | |
| CN | 114707360 | A | 05 July 2022 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP S6275351 A

- JP 2004184234 A

### Non-patent literature cited in the description

- **ENOKIZONO**. Two-Dimensional Vector Magnetic Property. *Journal of the Magnetics Society of Japan*, 2003, vol. 27 (2)
- Two-dimensional magnetic properties of grain-oriented electrical steel sheets. **WATANABE** ; **YANASE** ; **OKAZAKI**. Papers of Technical Meeting on Magnetics. IEE Japan, 2008, 19-24

- Examination of measurement methods under CCW/CW conditions in the high magnetic flux density region. **MAEDA** ; **SHIMOJI** ; **TODAKA** ; **ENOKIZONO**. Papers of Technical Meeting on Magnetics. IEE Japan, 2007, 1-4